**Europäisches Patentamt**

**European Patent Office**

**Office européen des brevets**

(19)

(11) Publication number : **0 434 392 B1**

(12) **EUROPEAN PATENT SPECIFICATION**

(45) Date of publication of patent specification :
15.06.94 Bulletin 94/24

(51) Int. Cl.⁵ : **H01L 23/10, H01L 23/15,**
**H01L 21/52**

(21) Application number : **90313915.2**

(22) Date of filing : **19.12.90**

(54) Semiconductor device having improved adhesive structure and method of producing the same.

(30) Priority : **19.12.89 JP 329244/89**
**25.12.89 JP 337585/89**
**23.08.90 JP 221809/90**

(43) Date of publication of application :
**26.06.91 Bulletin 91/26**

(45) Publication of the grant of the patent :
**15.06.94 Bulletin 94/24**

(84) Designated Contracting States :
**DE FR GB**

(56) References cited :
**US-A- 4 537 863**
**US-A- 4 704 626**
**US-A- 4 827 082**
**PATENT ABSTRACTS OF JAPAN vol. 11, no.**
**195 (E-518)(2642) 23 June 1987, & JP-A-62**
**022459**
**PATENT ABSTRACTS OF JAPAN vol. 11, no.**
**376 (E-563)(2823) 08 December 1987, & JP-A-62**
**145750**
**PATENT ABSTRACTS OF JAPAN vol. 10, no.**
**313 (E-448)(2369) 24 October 1986, & JP-A-61**
**125052**
**PATENT ABSTRACTS OF JAPAN vol. 12, no.**
**268 (E-638)() 27 July 1988, & JP-A-63 052447**

(56) References cited :
**PATENT ABSTRACTS OF JAPAN vol. 11, no.**
**130 (E-502)(2577) 23 April 1987, & JP-A-61**
**276239**
**PATENT ABSTRACTS OF JAPAN vol. 11, no.**
**88 (E-490)() 18 March 1987, & JP-A-61 241952**

(73) Proprietor : **FUJITSU LIMITED**
**1015, Kamikodanaka**
**Nakahara-ku**
**Kawasaki-shi Kanagawa 211 (JP)**

(72) Inventor : **Takenaka, Takeshi**
**1331-A-206 Shimosakunobe,**
**Takatsu-ku**
**Kawasaki-shi, Kanagawa 213 (JP)**
Inventor : **Hamano, Toshio**
**236-1-518 Suwa,**
**Takatsu-ku**
**Kawasaki-shi, Kanagawa 213 (JP)**
Inventor : **Saito, Takekiyo**
**1028-2-223 Kaminakazatocho,**
**Isogo-ku**
**Yokohama-shi, Kanagawa 235 (JP)**

(74) Representative : **Stebbing, Timothy Charles et**
**al**
**Haseltine Lake & Co.**
**Hazlitt House**
**28 Southampton Buildings**
**Chancery Lane**
**London WC2A 1AT (GB)**

EP 0 434 392 B1

## Description

BACKGROUND OF THE INVENTION

The present invention generally relates to a semiconductor device, and more particularly to an improvement in adhering structural elements, such as a package and a cover, to each other. Further, the present invention is concerned with a method of producing such a semiconductor device.

Recently, semiconductor chips of large sizes have been used in order to realize a high integration density. As the semiconductor chip size increases, a package which accommodates a semiconductor chip also increases. A lid (which is also referred to cap or cover) is, for example, adhered to a stage surface of the package by an adhesive. It is necessary to obtain a sufficient strength of an adhesive portion between the package and the lid, particularly when the package accommodates a large-size semiconductor chip.

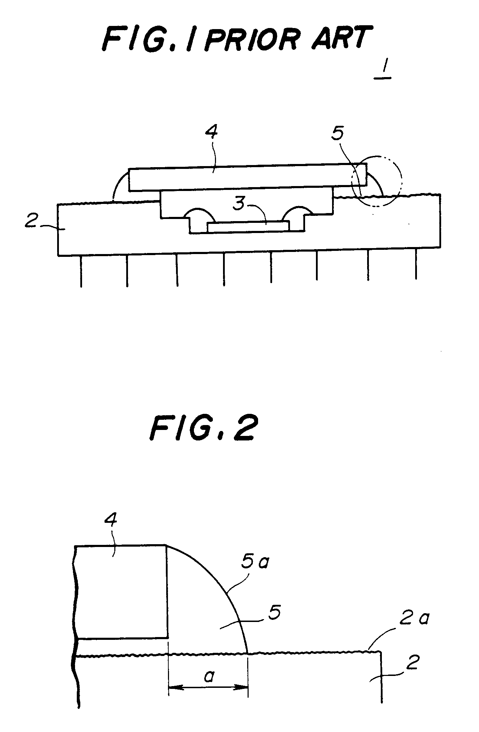

Referring to FIG. 1, there is illustrated a conventional frit seal type semiconductor device 1. FIG. 2 is an enlarged diagram of a portion surrounded by the chain line shown in FIG. 1. The semiconductor device 1 is composed of a ceramic package 2, a semiconductor chip 3 on which integrated circuits are formed, a lid 4 and a glass layer 5. The ceramic package 2 has a recess portion in which the semiconductor chip 3 is accommodated. The lid 4 is adhered to a stage (upper) surface of the ceramic package 2 by the glass layer 5. Generally, as the chip size increases, a weight applied to the lid 4 is varied in order to improve reliability of sealing the semiconductor device.

The applicants conducted a thermal shock test based on an MIL standard, MIL-STD-883C 1011 COND.A, in which samples of the semiconductor device 1 shown in Fig. 1 are alternately put into a chamber maintained at 0°C and a chamber at 100°C. The results of the thermal shock test are shown in Table 1, which will be shown later. When the alternation had been carried out about 300 times, a crack appeared in a portion of the glass layer 5 along a peripheral edge of the lid 4 of each of the samples. This means that the adhesive strength between the glass layer 5 and the ceramic package 2 is not sufficient and the adhesive portion is weak with respect to thermal shocks.

The reasons are thought to be as follows. The stage surface 2a of the ceramic package 2 has a roughness between about 0.3 and 0.4, expressed as a center-line average roughness Ra. As is known, the center-line average roughness Ra is defined as $Ra = (1/1) \int_0^1 |f(x)| dx$ where x represents the direction of the center line, 1 is a measurement length, and f(x) (=y) is a roughness curve. Thus, a sufficient anchor effect is not obtained where the anchor effect shows the degree of adhesion. The meniscus portion 5a (peripheral taper portion) of the glass layer 5 is convex. As a result, the portion of the glass layer 5 extending outward from the edge of the lid 4 has a length "a" which is insufficient for the purposes of adhesion. Further, the difference between the coefficients of thermal expansion of the ceramic package 2 and of the glass layer 5 affects the occurrence of cracks. Similar problems occur between the semiconductor chip 3 and the package 2.

It is a general object of the present invention to provide an improved semiconductor device in which the above-mentioned disadvantages are alleviated.

A more specific object of the present invention is to provide a semiconductor device in which an adhesive portion between a lid and a package, or between a semiconductor chip and its package, has an increased adhesion strength so that the semiconductor device is resistant to thermal shocks.

According to a first aspect of the invention there is thus provided a semiconductor device including: a package; a semiconductor chip provided on the package; a lid sealing the semiconductor chip; an adhesive layer between the package and the lid; and an intermediate layer between the adhesive layer and either the package or the lid, and comprising a major component being the same as a major component of the package or the lid respectively; characterised in that the surface of the intermediate layer which is in contact with the adhesive layer has a roughness (Ra) greater than that of the surface of whichever of the package or the lid it is attached to.

Similarly, according to a second aspect of the invention there is provided a semiconductor device comprising: a package; an intermediate layer formed on the package; an adhesive layer formed on the intermediate layer; a semiconductor chip formed on the adhesive layer; and a means fixed on the package for sealing the semiconductor chip; characterised in that the intermediate layer contains a major component which is the same as a major component of the package, and the surface of the intermediate layer is rougher than that of the package.

Still another object of the present invention is to provide a method of producing a semiconductor device having an intermediate layer such as the above.

Therefore, according to a third aspect of the invention, there are provided corresponding methods of pro-

EP 0 434 392 B1

ducing a semiconductor device as set out in claims 16 and 17.

Other objects, features and advantages of the present invention will become more apparent from the following detailed description when read in conjunction with the accompanying drawings, in which:

Fig. 1 is a cross-sectional view of a conventional semiconductor device;

Fig. 2 is an enlarged side view of a portion surrounded by the chain line shown in Fig. 1;

Fig. 3 is a cross-sectional view of a semiconductor device according to a first embodiment of the present invention;

Fig. 4 is a partially exploded perspective view of the semiconductor device shown in Fig. 3;

Fig. 5 is an enlarged view of a portion of the semiconductor device shown in Fig. 3;

Fig. 6 is a cross-sectional view of another semiconductor device according to a variant of the first embodiment of the present invention;

Fig. 7 is a perspective view of the semiconductor device shown in Fig. 6;

Fig. 8 is a cross-sectional view of a semiconductor device according to a second embodiment of the present invention;

Fig. 9 is an enlarged view of a part of the semiconductor device shown in Fig. 8;

Fig. 10 is a cross-sectional view of a semiconductor device according to a third embodiment of the present invention;

FIG. 11 is a cross-sectional view of a semiconductor device according to a fourth preferred embodiment of the present invention;

FIG. 12 is a cross-sectional view of a semiconductor device according to a fifth preferred embodiment of the present invention;

FIG. 13 is a perspective view of a package shown in FIG. 12; and

FIG. 14 is a cross-sectional view of another semiconductor device according to the fifth preferred embodiment of the present invention.

DESCRIPTION OF THE PREFERRED EMBODIMENTS

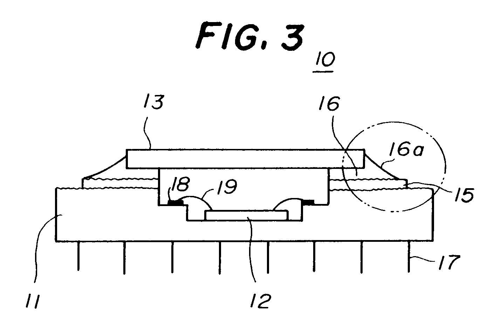

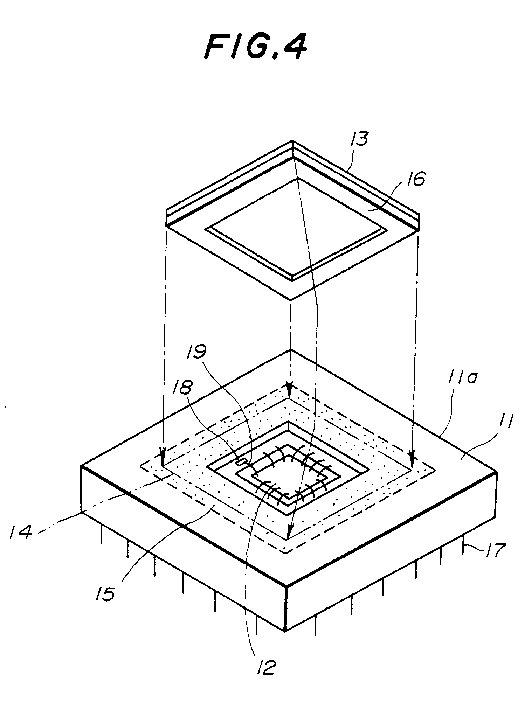

A description will now be given of a first preferred embodiment of the present invention. Referring to FIGS. 3 and 4, there is illustrated a semiconductor device 10 according to the first preferred embodiment of the present invention. The semiconductor device in FIGS. 3 and 4 has a pin grid array of terminal pins, and a frit type sealing.

The semiconductor device 10 has an alumina package 11, which has a recess portion in a stage surface thereof. A semiconductor chip 12 is accommodated in the recess portion of the alumina package 11 and fixed thereto by using, for example, gold, gold-silicon, silver epoxy resin, silver polyimid resin or silver glass. When gold-silicon is used, a gold is plated on the recess portion of the alumina package 11. It is preferable that the semiconductor chip be fixed to the package 11, as will be described later. A lid 13 formed of a ceramic substance, such as alumina, is positioned at a lid mounting portion 14 of a stage surface 11a of the alumina package 11, and hermetically seals the semiconductor chip 12. In FIG. 4, the lid mounting portion 14 is indicated by the two-dot chain line. An alumina paste layer (intermediate layer) 15 is coated on a portion of the stage surface 11a which includes the lid mounting portion 14 and which is wider than the lid mounting portion 14. A plurality of pin (lead) terminals 17 which are electrically coupled to inner patterns 18 on the stage surface of the alumina package 11 extend from the alumina package 11. The inner patterns are electrically connected to integrated circuits formed on the semiconductor chip 12 via bonding wires 19.

The alumina paste layer 15 is formed of a paste which contains alumina ($Al_2O_3$) and glass. For example, an alumina paste contains a mixture of alumina particles having diameters between 5μm and 6μm, and a glass component. Such an alumina paste is printed on the above-mentioned portion of the stage surface 11a by a conventional screen printing process. The printed alumina paste layer has a thickness of, for example, 30μm. After that, the printed alumina paste layer is sintered at a temperature between 1500°C and 1600°C for a few hours. The alumina paste layer after it is sintered is about 20μm thick. The alumina paste layer 15 is formed in the above-mentioned way.

The surface of the alumina paste layer 15 has a center line average roughness Ra between about 0.5 and 0.8. The roughness of the surface of the alumina paste layer 15 is approximately twice that of the stage surface 11a of the package 11. This results from fact that the stage surface 11a of the package 11 is smoothed due to the function of a pressure which is applied during a process in which a plurality of alumina layers of the alumina package 11 are stacked. On the other hand, roughness of the surface of the alumina paste layer 15 is created due to the use of a mesh mask during the screen printing process and the fact that no pressure is applied during the formation of the alumina paste layer 15. It should be noted that even when alumina particles having diameters substantially identical to those of alumina particles used for forming the alumina package,

3

the surface of the alumina paste layer 15 becomes rougher than that of the alumina package 11. If alumina particles having diameters (in the range of, for example, 5μm to 6μm) larger than alumina particles used for forming the alumina package 11 are used for forming the alumina paste layer 15, the surface roughness of the alumina paste layer 15 will be enhanced. The above holds true for other ceramic particles.

However, it is preferable that in the following cases, alumina particles having diameters larger than those for the alumina package 11 be used for forming the alumina paste layer 15. For example, there is a case where the lid 13 is placed at an intermediate step portion of the alumina package 11. The top surface of the alumina package is coupled, via one or more intermediate step portions, to the bottom surface thereof where the semiconductor chip 12 is placed. It is impossible to coat an alumina paste on the intermediate step portion of the alumina package 11 at the last production step. In this case, an alumina paste is coated on the intermediate step portion, and thereafter, the top alumina layer is placed on the intermediate portion and sintered. During the above step, a pressure is applied to the alumina paste layer formed on the intermediate portion, so that a sufficient surface roughness of the alumina paste layer cannot be obtained. In this case, by forming the alumina paste layer of alumina particles having larger diameters, a sufficient surface roughness thereof can be obtained. Further, the following case should use alumina particles having larger diameters to form the alumina paste layer. If the alumina package 11 and the alumina paste layer 15 are formed of very fine alumina particles, a sufficient surface roughness of the alumina paste layer 15 will not be obtained even if it is formed by the screen printing process. In this case, it is preferable to form the alumina paste layer of alumina particles having diameters much larger than those of very fine alumina particles.

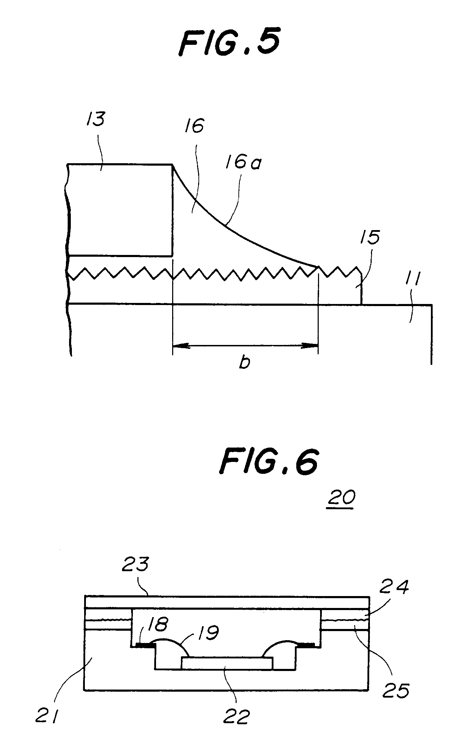

A glass layer 16 is formed by melting glass and solidifying melted glass. The glass layer 16 functions as a sealing member, and is interposed between the lid 13 and the package 11. A surface of the glass layer 16 on the side of the alumina package 11 is adhered to the corresponding surface of the alumina paste layer 15. It is confirmed that glass has a good liquidity on an alumina paste layer, as compared with a ceramic layer. Thus, the glass layer 16 expands on the alumina paste layer 15 very well during the melting process and, as shown in FIG. 5, a large meniscus portion 16a of the glass layer 16 is obtained. It will be noted that the meniscus portion 16a, that is, the outer surface of the glass layer 16a is concave. As a result, the length 'b' of a portion of the glass layer 16 outward extending from the edge of the lid 13 due to the capillary action is much greater than the aforementioned length 'a' shown in FIG. 2.

Table 1 shows the results of the aforementioned thermal shock test to the conventional device 1 (FIG. 1) and the device 10 (FIG. 3) according to the first preferred embodiment of the present invention.

## Table 1

| Number of times that thermal shocks are applied | 100 | 200 | 300 | 1000 | 2000 |
|---|---|---|---|---|---|
| Device 10 (Ra = 0.5 - 0.8) | 0/10 | 0/10 | 0/10 | 0/10 | 0/10 |
| Device 1 (Ra = 0.3 - 0.4) | 0/20 | 0/20 | 19/20 | ... | ... |

In table 1, 0/10 means that 10 samples did not have any cracks at all, and 19/20 means that cracks occurred in 19 of 20 samples. It can be seen from Table 1 that none of the 10 samples of the device 10 did not have any cracks at all even after the thermal shocks were repeatedly applied thereto 2000 times. On the other hand, cracks took place in 19 samples of the 20 samples of the device 10 after the thermal shocks were repeatedly applied thereto only 300 times. It can be concluded that the use of the alumina paste layer 15 extremely improves resistance to thermal shocks.

It is considered that the above-mentioned excellent advantages of the semiconductor device 10 are due to the following reasons. First, since the surface of the alumina paste layer 15 is rough, a great anchor effect between the glass layer 16 and the alumina paste layer 15 can be obtained. Second, since the alumina paste layer 15 has a large roughness of surface, the adhesion area in which the glass layer 16 and the alumina paste layer 15 are adhered to each other is increased. Third, since the length 'b' of the outward extending portion of the glass layer 16 is much greater than the length 'a' of the outward extending portion of the glass layer 5, the adhesive area is also increased, so that the meniscus portion 16a of the glass layer 16 becomes concave. The adhesion strength of the glass layer 16 with respect to the alumina paste layer 15 (alumina package 11) is increased due to the increased anchor effect and the increased adhesion area. Additionally, it becomes easy to position the lid 13 on the alumina package 11, since it is sufficient to position the lid 13 with respect to the peripheral edges of the alumina paste layer 15. When the lid 13 is adhered to the alumina package 11, glass is heated so that it is melted. During the heating process, the alumina paste layer 15 is resistant to such heating, so that there is no problem.

It may be possible to employ an alternative in which the alumina package 11 is formed of ceramic particles having diameters larger than normal diameters. In this case, it is possible to obtain a large roughness of the surface of the alumina package 11 after it is sintered. However, in this case, the strength of the alumina package 11 will deteriorate and the contraction ratio thereof will vary. For these reasons, the above-mentioned alternative is not practical. On the other hand, when ceramic particles having diameters smaller than normal diameters are used for forming the alumina package 11 in order to increase the strength thereof, the surface of the alumina package 11 has a small roughness after it is sintered. In this case, the alumina paste layer 15 containing ceramic particles having diameters larger than those of the alumina package 11 functions as if the surface of the alumina package 11 has a large roughness.

It is possible to replace the alumina paste layer 15 by another layer formed of a paste substance. In this case, it is important to select the material of the paste layer 15 so that the paste layer 15 has a major component which is the same as that of the package 11. For example, when the package 11 is formed of aluminum nitride (AlN) and glass, the paste layer 15 is formed of a paste of aluminum nitride. When the package is formed of mullite ($Al_6Si_2O_{13}$), the paste layer 15 is formed of a mullite paste.

The paste layer 15 may consist of a plurality of stacked layers, as will be described later. It is possible to coat a paste layer on a surface portion of the lid in contact with the glass layer 16, as will be described later. In this case, the adhesive strength of the lid 13 with respect to the alumina package 11 increases, so that the semiconductor device becomes more resistant to thermal shocks.

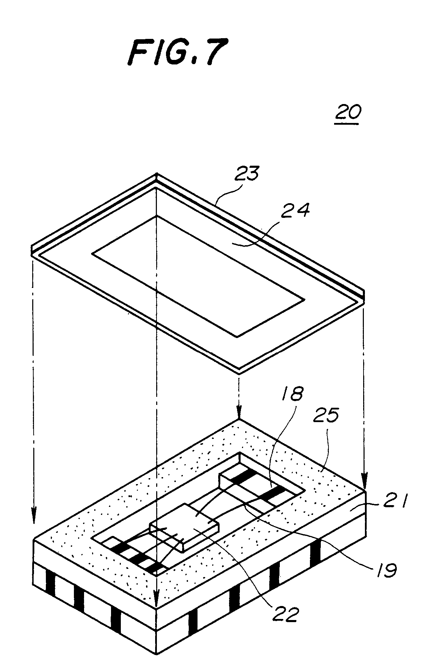

Referring to FIGS. 6 and 7, there is illustrated another semiconductor device 20 according to the first preferred embodiment of the present invention. The semiconductor device 20 in FIGS. 6 and 7 is an LCC (leadless chip carrier) type semiconductor device. The semiconductor device 20 has a glass epoxy resin package 21 having a recess portion formed on a stage surface in which a semiconductor chip 22 is accommodated. The semiconductor chip 22 is adhered to the package 21 by, for example, a silver epoxy resin, preferably according to a sixth preferred embodiment of the present invention. A lid 23 is formed of glass or glass epoxy resin. An epoxy adhesive 24 is coated on a peripheral area of a lower surface of the lid 23. A solder resist layer 25 is formed on the stage surface of the package 21 by printing an epoxy-based solder resist by the screen printing process and by curing it at a temperature between 140°C - 150°C. The cured solder resist layer 25 is, for example, 10 - 30μm thick. The surface of the solder resist layer 25 has a center line average roughness Ra in the range of 1.0 to 4.0. Such a roughness of the surface is much greater than that of the glass epoxy resin package 21. The lid 23 is adhered to the stage surface of the package 21 by the epoxy adhesive 24. The use of the solder resist layer 25 enhances the adhesive strength between the epoxy adhesive 24 and the package 21, so that the semiconductor device 20 has an improved thermal shock resistant characteristic. It is further possible to coat the solder resist layer 25 on the portion of the lower surface of the lid 23 in contact with the epoxy adhesive 24. This will further increase the adhesive strength and thermal shock resistance.

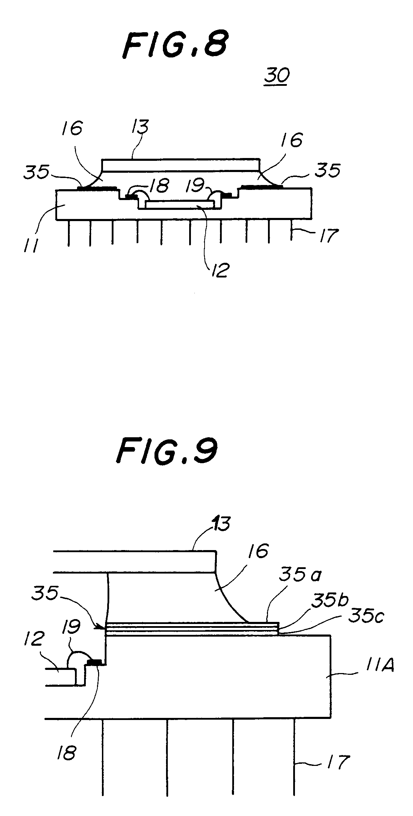

A description will be given of a semiconductor device 30 according to a second embodiment of the present invention with reference to FIG. 8, in which those parts which are the same as those shown in FIG. 3 are given the same reference numerals. An alumina paste layer 35 shown in FIG. 8 is substituted for the alumina paste layer 15 shown in FIG. 3. The alumina paste layer 35 is formed by once coating, on the stage surface of the alumina package 11, a material having a coefficient of thermal expansion different from that of the package 11 and that of the glass layer 16. That is, the alumina paste layer 35 stepwise absorbs the difference between the coefficient of thermal expansion of the alumina package 11 and the coefficient of thermal expansion of the glass layer 16.

Generally, the coefficient of thermal expansion of alumina is determined based on the ratio of alumina to glass contained therein. Thus, it is possible to change the coefficient of thermal expansion of alumina by changing the above ratio. For example, when alumina contains alumina by 60% and borosilicate lead glass by 40%, the coefficient of thermal expansion of such alumina is approximately equal to $5.4 \times 10^{-6}$/°C. Thus, the alumina paste layer 35 is provided at a weak adhesive portion between the glass layer 16 and the package 11, that is, at a portion having a large difference of the coefficients of thermal expansion. In other words, the alumina paste layer 35 functions as a buffer layer provided between the different coefficients of thermal expansion.

For example, the coefficient of thermal expansion of the alumina package 11, $\alpha_1$, is equal to $7.6 \times 10^{-6}$ /°C, the coefficient of thermal expansion of the glass layer 16, $\alpha_2$, is equal to $6.9 \times 10^{-6}$/°C, and the coefficient of thermal expansion of the lid 13, $\alpha_3$, is equal to $7.2 \times 10^{-6}$/°C. Thus, the difference between the coefficients of thermal expansion obtained at an interface between the lid 13 and the glass layer 16, $\Delta 1 (= \alpha_3 - \alpha_2)$, is equal to $0.3 \times 10^{-6}$/°C, and the difference between the coefficients of thermal expansion obtained at an interface between the glass layer 16 and the package 11, $\Delta 2 (= \alpha_1 - \alpha_2)$, is equal to $0.7 \times 10^{-6}$/°C. That is, the difference at the interface between the glass layer 16 and the package 11 is greater than that at the interface between the lid 13 and the glass layer 16. With the above in mind, the coefficient of thermal expansion of the alumina

paste layer 35, $\alpha_4$, is set to, for example, $7.25 \times 10^{-6}/°C$. In this case, the following coefficient-of-thermal-expansion differences are obtained: $\Delta 3 = \alpha_1 - \alpha_4 = 0.35 \times 10^{-6}/°C$, and $\Delta 4 = \alpha_4 - \alpha_2 = 0.35 \times 10^{-6}/°C$. As a result, the resistance to thermal shocks is enhanced.

Generally, in order to modify the quality of alumina forming the package, it is necessary to match it with the quality of the glass layer 16 in view of mechanical properties (such as a bending strength), electrical properties (such as dielectric constant, dielectric dissipation factor, volume resistivity, breakdown voltage), and other properties (such as thermal conductivity). According to the second embodiment of the present invention, the alumina paste layer 35 is coated on only portions which are sealed by the lid 13, and the coefficient of thermal expansion is stepwise or substantially gradually varied between the glass layer 16 and the package 11, so that the sealing properties obtained between the package 11 and the lid 13 can easily be improved.

Referring to FIG. 9, there is illustrated a variation of the second embodiment of the present invention. The semiconductor device in FIG. 9 has a package 11A formed of a high thermal conductivity ceramic material, such as aluminum nitride (AlN). There is a large difference between the coefficient of such a high thermal conductivity ceramic material and that of the glass layer 16 formed of low-melting-point glass, and thus, a problem will occur regarding the adhesion between the package 11A and the lid 13. It will be noted that the coefficient of thermal expansion of aluminum nitride is about $5.0 \times 10^{-6}/°C$, and that of the glass layer 16 is about $6.9 \times 10^{-6}/°C$.

With the above fact in mind, the buffer layer 35 between the alumina nitride package 11A and the glass layer 16 is modified so that it consists of three layers 35a, 35b and 35c respectively containing alumina and glass. The layers 35a, 35b and 35c have mutually different coefficients of thermal expansion as follows. That is, the coefficient of thermal expansion of the layer 35a in contact with the glass layer 16 is the largest, and that of the layer 35c in contact with the alumina nitride package 11a is the smallest. The coefficient of thermal expansion of the layer 35b is an intermediate value between the coefficients of thermal expansion of the layers 35a and 35b. The coefficient of thermal expansion of the layer 35a is smaller than that of the glass layer 16, and the coefficient of thermal expansion of the layer 35c is greater than that of the aluminum nitride package 11A. The buffer layer 35 functions to absorb the difference between the coefficients of thermal expansion of the glass layer 16 and the aluminum nitride package 11A. It should be noted that the buffer layer 35 is not limited to the above three layers, but may have an arbitrary number of layers. It will be noted that the layers 35a and 35b and 35c are formed by performing the screen printing process three times.

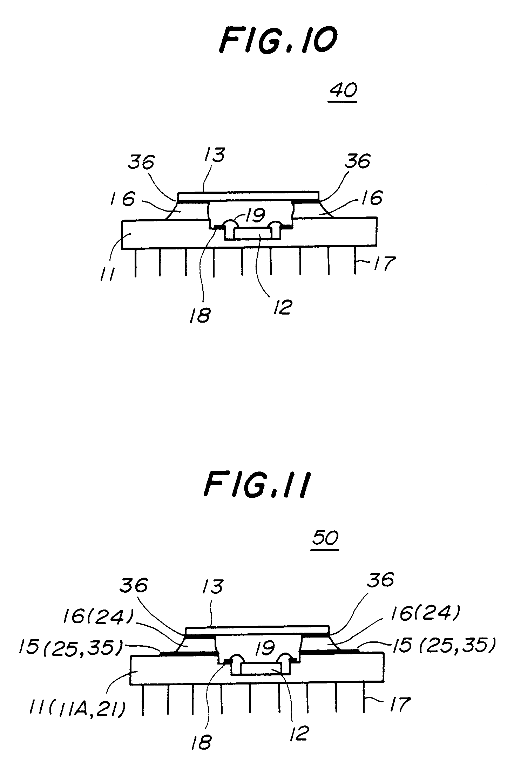

Referring to FIG. 10, there is illustrated a semiconductor device 40 according to a third preferred embodiment of the present invention. In FIG. 10, those parts which are the same as those shown in FIG. 3 are given the same reference numerals. An alumina paste layer 36 is provided between the lid 13 and the glass layer 16. The alumina paste layer 36 has a surface having a center line average roughness between 0.5 and 0.8. The alumina paste layer 36 contains alumina and glass so that the coefficient of thermal expansion thereof, $\alpha_5$, is equal to about $7.05 \times 10^{-6}/°C$. As a result, $\Delta 5 = \alpha_3 - \alpha_5 = 0.15 \times 10^{-6}/°C$, and $\Delta 6 = \alpha_5 - \alpha_2 = 0.15 \times 10^{-6}/°C$. With this arrangement, a gradual change of the coefficient of thermal expansion can be obtained between the glass layer 16 and the lid 13, so that the adhesion therebetween can be improved.

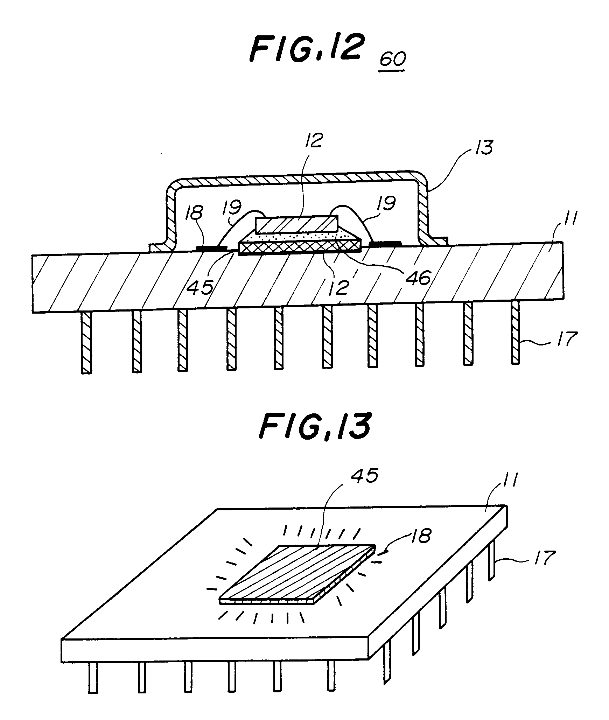

Referring to FIG. 11, there is illustrated a semiconductor device 50 according to a fourth embodiment of the present invention, in which those parts which are the same as those shown in the previous figures are given the same reference numerals. The semiconductor device 50 corresponds to the combination of the first and second (third) embodiment of the present invention. The alumina paste layer 15 (25, 35) is provided between the package 11 (11A) and the glass layer 16, and the alumina paste layer 36 is provided between the glass layer 16 and the lid 13. The structure shown in FIG. 11 will have the most effective adhesion between the package 11 (11A), the glass layer 16 and the lid 13.

It will be noted that the structures shown in FIGS. 8 through 10 can be applied to semiconductor devices having a glass epoxy resin package, as shown in FIGS. 6 and 7. That is, the alumina paste layer 35 shown in FIGS. 8 and 9 is replaced by a solder resist layer 25, and the alumina paste layer 36 shown in FIG. 10 is replaced by a solder resist layer.

A description will now be given of a semiconductor device 60 according to a fifth embodiment of the present invention with reference to FIG. 12, in which those parts which are the same as those shown in the previous figures are given the same reference numerals. In FIG. 12, the member 13 is referred to as a cap. According to the fifth embodiment of the present invention, an alumina paste layer 45 is provided between the alumina package 11 and a silver (Ag) glass layer 46, on which the semiconductor chip 12 is mounted.

It will be noted that conventionally, gold-silicon has an eutectic temperature of 370°C. The alumina package 11 on which gold is coated is heated at a temperature higher than 370°C, so that eutectic gold-silicon is formed between gold plating and silicon chip, and the semiconductor chip 12 is fixed on the stage surface of the alumina package 11. It will be noted that as the chip size increases, the semiconductor chip 12 is greatly warped. A warp of the semiconductor chip 12 deteriorates the adhesion between the semiconductor chip 12 and the alumina package 11. In which case, a void will be liable to occur in the gold-silicon layer 46, and a stress concentration will occur around the void. Thus, the residual stress and thermal stress will increase. In the worst case, a crack will take place in the semiconductor chip 12.

In order to eliminate the above-mentioned problems, conventionally, a pellet (thin piece) member made of gold (Au) or gold-silicon (Au-Si) is provided between the semiconductor chip 12 and the alumina package 11, or a substance having a small Young's modulus, such as a silver epoxy resin, silver polyimid resin, silver glass or aluminum glass, is provided therebetween. However, the use of such a pellet member, particularly containing gold, increases the production cost, and the use of the above substance does not provide a good liquidity and good meniscus. The fifth embodiment of the present invention using a ceramic paste layer 45 overcomes these problems.

The alumina paste layer 45 is formed by coating a paste composed of alumina and glass by the screen printing process and sintering it at a temperature of about 1500°C - 1600°C. As has been described previously, the alumina paste layer 45 after it is sintered is about 20$\mu$m thick, and a surface having a roughness between 0.5 and 0.8. It is preferable that the alumina paste layer 45 have a coefficient of thermal expansion between that of silicon of the semiconductor chip 12 (which is approximately equal to 3.5 - 4 x 10$^{-6}$) and alumina of the alumina package 11 (which is approximately equal to 7 x 10$^{-6}$). The silver glass layer 46 is formed on the alumina paste layer 45 by a dispensing process. It is preferable to use silver glass in view of the production cost.

FIG. 13 is a perspective view of the alumina package 11 shown in FIG. 12. The alumina package 11 has a dimension of 35mm x 35mm and a thickness of 2mm, for example. The alumina paste layer 45 also functions as an alignment mark which is used in the chip bonding process. It is possible to modify the alumina paste layer 45 so that it consists of a plurality of stacked layers.

The use of the alumina paste layer 45 increases the adhesion between the semiconductor chip 12 and the alumina package 11, since the alumina paste layer 45 has an increased roughness which increases the anchor effect and meniscus. Further, the use of the alumina paste layer 45 relaxes the stress occurring when the semiconductor chip 12 is fixed to the alumina package 11 since it has a coefficient of thermal expansion between that of the semiconductor chip 12 and that of the alumina package 11.

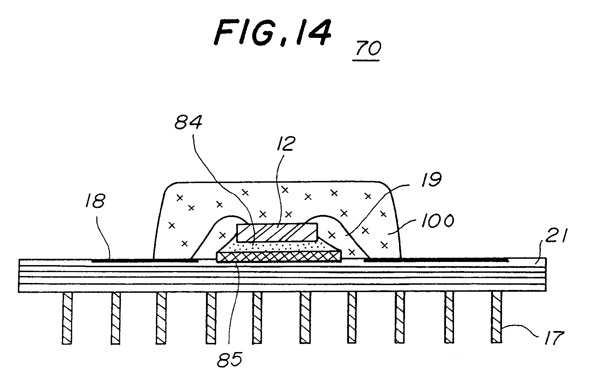

Referring to FIG. 14, there is illustrated a PGA type semiconductor device 70 according to the fifth preferred embodiment of the present invention. The semiconductor device 70 has the glass epoxy resin package 21. A solder resist layer 85 formed of an epoxy-based solder resist is coated on the package 21 by the screen printing process, and is cured at about 150°C. The solder resist layer 85 has a heat resistance up to only about 200°C, and is thus used when the package 21 is formed of a material having a low heat resistance, such as a resin package or mold package. The solder resist layer 85 has a surface roughness so that Ra = 1.0 - 4.0. It is preferable that the solder resist layer 85 have a coefficient of thermal expansion so that it is between that of silicon and that of the package 21.

The present invention may be applied to a ceramic or resin type dual in-line package (DIP) and a ceramic or resin type flat package (FP).

## Claims

1. A semiconductor device including:
   a package (11,21);
   a semiconductor chip (12,22) provided on the package;
   a lid (13, 23) sealing the semiconductor chip (12);
   an adhesive layer (16,24) between the package (11,21) and the lid (13,23); and
   an intermediate layer (15, 25, 35, 36) between the adhesive layer and either the package or the lid, and comprising a major component being the same as a major component of the package or the lid respectively;
   characterised in that the surface of the intermediate layer which is in contact with the adhesive layer has a roughness (Ra) greater than that of the surface of whichever of the package or the lid it is attached to.

2. A semiconductor device as claimed in claim 1, in which the intermediate layer (35) comprises a succession of stacked layers (35a, 35b, 35c).

3. A semiconductor device as claimed in claim 2, in which the successive stacked layers (35a, 35b, 35c) have coefficients of thermal expansion between the coefficient of thermal expansion of the package (11) and that of the adhesive layer (16).

4. A semiconductor device as claimed in claim 3, in which the coefficients of thermal expansion of the said layers (35a, 35b, 35c) of the intermediate layer (35) increase or decrease in the stacking order of the layers.

5. A semiconductor device as claimed in any preceding claim, in which the intermediate layer (15, 25, 35) is formed on the package (11,21) so as to surround the semiconductor chip (12).

6. A semiconductor device as claimed in any preceding claim, in which the intermediate layer (15, 25, 35) is located between the package (11,21) and the adhesive layer (16, 24) and a second intermediate layer (36) is provided between the adhesive layer (16, 24) and the lid (13), this second intermediate layer likewise comprising a major component which is the same as that of the lid.

7. A semiconductor device as claimed in claim 6, wherein the coefficient of thermal expansion of the second intermediate layer (36) is between that of the adhesive layer (16, 24) and that of the lid (13).

8. A semiconductor device comprising:
   a package (11, 21);
   an intermediate layer (45, 85) formed on the package;
   an adhesive layer (46, 84) formed on the intermediate layer (45, 85);
   a semiconductor chip (12) formed on the adhesive layer; and
   a means (13, 100) fixed on the package for sealing the semiconductor chip;
   characterised in that the intermediate layer (45) contains a major component which is the same as a major component of the package (11), and the surface of the intermediate layer (45) is rougher than that of the package (11).

9. A semiconductor device as claimed in any preceding claim, in which the intermediate layer (15, 25, 35, 45, 85) and the package (11, 11A, 21) or, if appropriate, the lid, each comprise particles of the said major component, and the particles of the major component in the intermediate layer are larger than those in the package or lid.

10. A semiconductor device as claimed in any preceding claim, in which the coefficient of thermal expansion of the intermediate layer (15, 25, 35, 45, 85) is between that of the package (11, 21) or, if appropriate, the lid, and that of the adhesive layer (16, 24, 46, 84).

11. A semiconductor device as claimed in any preceding claim, in which the said major component of the first intermediate layer (15, 35, 45) and of the package (11) or lid is a ceramic material.

12. A semiconductor device as claimed in claim 11, in which the said major component is alumina, aluminium nitride or mullite, the or each intermediate layer (15, 35, 45) comprising a paste including this ceramic material.

13. A semiconductor device as claimed in claim 11 or 12, in which the first intermediate layer (15, 35) contains glass.

14. A semiconductor device as claimed in any of claims 1 to 10, in which the said major component of the first intermediate layer (25, 85) and of the package (21) or lid is a resin.

15. A semiconductor device as claimed in claim 14, in which the intermediate layer (25, 85) comprises an epoxy-based solder resist.

16. A method of producing a semiconductor device including a package (11, 21), a semiconductor chip (12,22) mounted on the package, and a cap (13, 23) sealing the chip, the method comprising the steps of:
   forming, by a screen printing process, a paste on a predetermined area of the package (11, 21), the paste having a major component which is the same as that of the package;
   sintering or curing the paste at a predetermined temperature, so that an intermediate layer (15, 25, 35) is formed on the predetermined area of the package;
   and fixing the cap (13, 23) to the intermediate layer by using an adhesive (16, 24, 84) provided between the intermediate layer and the cap.

17. A method of producing a semiconductor device, comprising the steps of:

forming, by a screen printing process, a paste on a pre-determined area of a package (11), the paste having a major component which is the same as that of the package;

heat-treating the paste at a pre-determined temperature so that an intermediate layer (45) is formed on the predetermined area of the package (11);

fixing a semiconductor chip (12) to the intermediate layer (45) by using an adhesive (46) provided between the intermediate layer (45) and the semiconductor chip (12); and

fixing a sealing means (13, 100) to the package to seal the semiconductor chip (12).

18. A method as claimed in claim 16 or 17, in which the major component of the paste is alumina.

19. A method as claimed in claim 18, in which the paste includes glass in addition to the alumina.

20. A method as claimed in claim 16 or 17, wherein the package (21) comprises glass epoxy resin.

21. A method as claimed in claim 20, wherein the intermediate layer (25, 85) is a layer of epoxy-based solder resist.

22. A method as claimed in claim 21, wherein the heat-treatment of the paste comprises curing the paste at a pre-determined temperature.

**Patentansprüche**

1. Eine Halbleiteranordnung mit:

einer Packung (11, 21);

einem Halbleiterchip (12, 22), der auf der Packung vorgesehen ist;

einem Deckel (13, 23), der den Halbleiterchip (12) abdichtet;

einer Haftschicht (16, 24) zwischen der Packung (11, 21) und dem Deckel (13, 23); und

einer Zwischenschicht (15, 25, 35, 36) zwischen der Haftschicht und entweder der Packung oder dem Deckel, und mit einer Hauptkomponente, die dieselbe wie eine Hauptkomponente jeweils der Packung oder des Deckels ist;

dadurch gekennzeichnet, daß die Oberfläche der Zwischenschicht, die mit der Haftschicht in Kontakt ist, einen Rauhwert (Ra) hat, der größer als jener der Oberfläche der Packung oder des Deckels ist, welcher auch immer, an der sie befestigt ist.

2. Eine Halbleiteranordnung nach Anspruch 1, bei der die Zwischenschicht (35) eine Folge von gestapelten Schichten (35a, 35b, 35c) umfaßt.

3. Eine Halbleiteranordnung nach Anspruch 2, bei der die aufeinanderfolgenden gestapelten Schichten (35a, 35b, 35c) Wärmeausdehnungskoeffizienten haben, die zwischen dem Wärneausdehnungskoeffizienten der Packung (11) und dem der Haftschicht (16) liegen.

4. Eine Halbleiteranordnung nach Anspruch 3, bei der die Wärmeausdehnungskoeffizienten der genannten Schichten (35a, 35b, 35c) der Zwischenschicht (35) in der Stapelreihenfolge der Schichten zunehmen oder abnehmen.

5. Eine Halbleiteranordnung nach irgendeinem vorhergehenden Anspruch, bei der die Zwischenschicht (15, 25, 35) auf der Packung (11, 21) gebildet ist, um den Halbleiterchip (12) zu umgeben.

6. Eine Halbleiteranordnung nach irgendeinem vorhergehenden Anspruch, bei der die Zwischenschicht (15, 25, 35) zwischen der Packung (11, 21) und der Haftschicht (16, 24) angeordnet ist, und eine zweite Zwischenschicht (36) zwischen der Haftschicht (16, 24) und dem Deckel (13) vorgesehen ist, wobei diese zweite Zwischenschicht gleichfalls eine Hauptkomponente umfaßt, die dieselbe wie jene des Deckels ist.

7. Eine Halbleiteranordnung nach Anspruch 6, bei der der Wärmeausdehnungskoeffizient der zweiten Zwischenschicht (36) zwischen dem der Haftschicht (16, 24) und dem des Deckels (13) liegt.

8. Eine Halbleiteranordnung mit:

einer Packung (11, 21);

einer Zwischenschicht (45, 85), die auf der Packung gebildet ist;

einer Haftschicht (46, 84), die auf der Zwischenschicht (45, 85) gebildet ist;

einem Halbleiterchip (12), der auf der Haftschicht gebildet ist; und

einem Mittel (13, 100) zum Abdichten des Halbleiterchips, das an der Packung befestigt ist;

dadurch gekennzeichnet, daß die Zwischenschicht (45) eine Hauptkomponente enthält, die dieselbe wie eine Hauptkomponente der Packung (11) ist, und die Oberfläche der Zwischenschicht (45) rauher als die der Packung (11) ist.

9. Eine Halbleiteranordnung nach irgendeinem vorhergehenden Anspruch, bei der die Zwischenschicht (15, 25, 35, 45, 85) und die Packung (11, 11A, 21) oder, falls zutreffend, der Deckel jeweils Partikel der genannten Hauptkomponente umfassen und die Partikel der Hauptkomponente in der Zwischenschicht größer als jene in der Packung oder dem Deckel sind.

10. Eine Halbleiteranordnung nach irgendeinem vorhergehenden Anspruch, bei der der Wärmeausdehnungskoeffizient der Zwischenschicht (15, 25, 35, 45, 85) zwischen dem der Packung (11, 21) oder, falls zutreffend, des Deckels und jenem der Haftschicht (16, 24, 46, 84) liegt.

11. Eine Halbleiteranordnung nach irgendeinem vorhergehenden Anspruch, bei der die genannte Hauptkomponente der ersten Zwischenschicht (15, 35, 45) und der Packung (11) oder des Deckels ein Keramikmaterial ist.

12. Eine Halbleiteranordnung nach Anspruch 11, bei der die genannte Hauptkomponente Aluminiumoxid, Aluminiumnitrid oder Mullit ist, wobei die oder jede Zwischenschicht (15, 35, 45) eine Paste umfaßt, die dieses Keramikmaterial enthält.

13. Eine Halbleiteranordnung nach Anspruch 11 oder 12, bei der die erste Zwischenschicht (15, 35) Glas enthält.

14. Eine Halbleiteranordnung nach einem der Ansprüche 1 bis 10, bei der die genannte Hauptkomponente der ersten Zwischenschicht (25, 85) und der Packung (21) oder des Deckels ein Harz ist.

15. Eine Halbleiteranordnung nach Anspruch 14, bei der die Zwischenschicht (25, 85) ein Lötresist auf Epoxybasis umfaßt.

16. Ein Verfahren zum Herstellen einer Halbleiteranordnung, die eine Packung (11, 21), einen Halbleiterchip (12, 22), der auf der Packung montiert ist, und eine Kappe (13, 23), die den Chip abdichtet, enthält, welches Verfahren die Schritte umfaßt:

Bilden einer Paste auf einem vorbestimmten Bereich der Packung (11, 21) durch ein Siebdruckverfahren, welche Paste eine Hauptkomponente hat, die dieselbe wie jene der Packung ist;

Sintern oder Aushärten der Paste bei einer vorbestimmten Temperatur, so daß eine Zwischenschicht (15, 25, 35) auf dem vorbestimmten Bereich der Packung gebildet wird;

und Befestigen der Kappe (13, 23) an der Zwischenschicht unter Verwendung eines Haftmittels (16, 24, 84), das zwischen der Zwischenschicht und der Kappe vorgesehen ist.

17. Ein Verfahren zum Herstellen einer Halbleiteranordnung mit den Schritten:

Bilden einer Paste auf einem vorbestimmten Bereich einer Packung (11) durch ein Siebdruckverfahren, welche Paste eine Hauptkomponente hat, die dieselbe wie jene der Packung ist;

Wärmebehandlung der Paste bei einer vorbestimmten Temperatur, so daß eine Zwischenschicht (45) auf dem vorbestimmten Bereich der Packung (11) gebildet wird;

Befestigen eines Halbleiterchips (12) an der Zwischenschicht (45) unter Verwendung eines Haftmittels (46), das zwischen der Zwischenschicht (45) und dem Halbleiterchip (12) vorgesehen ist; und

Befestigen eines Abdichtungsmittels (13, 100) an der Packung, um den Halbleiterchip (12) abzudichten.

18. Verfahren nach Anspruch 16 oder 17, bei dem die Hauptkomponente der Paste Aluminiumoxid ist.

19. Verfahren nach Anspruch 18, bei dem die Paste zusätzlich zu dem Aluminiumoxid Glas enhält.

20. Ein Verfahren nach Anspruch 16 oder 17, bei dem die Packung (21) Glas-Epoxyharz umfaßt.

21. Ein Verfahren nach Anspruch 20, bei dem die Zwischenschicht (25, 85) eine Schicht aus Lötresist auf Epoxybasis ist.

**22.** Ein Verfahren nach Anspruch 21, bei dem die Wärmebehandlung der Paste ein Aushärten der Paste bei einer vorbestimmten Temperatur umfaßt.


## Revendications

**1.** Dispositif à semiconducteur incluant :
un module (11, 21) ;
une puce semiconductrice (12, 22) prévue sur le module ;
un capuchon (13, 23) scellant la puce semiconductrice (12) ;
une couche adhésive (16, 24) entre le module (11, 21) et le capuchon (13, 23) ; et
une couche intermédiaire (15, 25, 35, 36) entre la couche adhésive et soit le module soit le capuchon, et comprenant un composant principal qui est respectivement le même qu'un composant principal du module ou du capuchon,
caractérisé en ce que la surface de la couche intermédiaire qui est en contact avec la couche adhésive présente une rugosité (Ra) supérieure à celle de la surface à laquelle le module ou le capuchon est fixé.

**2.** Dispositif à semiconducteur selon la revendication 1, dans lequel la couche intermédiaire (35) comprend une succession de couches empilées (35a, 35b, 35c).

**3.** Dispositif à semiconducteur selon la revendication 2, dans lequel les couches successives empilées (35a, 35b, 35c) présentent des coefficients de dilatation thermique situés entre le coefficient de dilatation thermique du module (11) et celui de la couche adhésive (16).

**4.** Dispositif à semiconducteur selon la revendication 3, dans lequel les coefficients de dilatation thermique desdites couches (35a, 35b, 35c) de la couche intermédiaire (35) croissent ou décroissent en suivant l'ordre d'empilement des couches.

**5.** Dispositif à semiconducteur selon l'une quelconque des revendications précédentes, dans lequel la couche intermédiaire (15, 25, 35) est formée sur le module (11, 21) de manière à entourer la puce semiconductrice (12).

**6.** Dispositif à semiconducteur selon l'une quelconque des revendications précédentes, dans lequel la couche intermédiaire (15, 25, 35) est située entre le module (11, 21) et la couche adhésive (16, 24) et une seconde couche intermédiaire (36) est prévue entre la couche adhésive (16, 24) et le capuchon (13), cette seconde couche intermédiaire comprenant pareillement un composant principal qui est le même que celui du capuchon.

**7.** Dispositif à semiconducteur selon la revendication 6, dans lequel le coefficient de dilatation thermique de la seconde couche intermédiaire (36) est situé entre celui de la couche adhésive (16, 24) et celui du capuchon (13).

**8.** Dispositif à semiconducteur comprenant :
un module (11, 21) ;
une couche intermédiaire (45, 85) formée sur le module ;
une couche adhésive (46, 84) formée sur la couche intermédiaire (45, 85) ;
une puce semiconductrice (12) formée sur la couche adhésive ; et
un moyen (13, 100) fixé sur le module pour sceller la puce semiconductrice,
caractérisé en ce que la couche intermédiaire (45) contient un composant principal qui est le même qu'un composant principal du module (11) et la surface de la couche intermédiaire (45) est plus rugueuse que celle du module (11).

**9.** Dispositif à semiconducteur selon l'une quelconque des revendications précédentes, dans lequel la couche intermédiaire (15, 25, 35, 45, 85) et le module (11, 11A, 21) ou éventuellement le capuchon, comprennent chacun des particules dudit composant principal et les particules du composant principal dans la couche intermédiaire sont plus grosses que celles dans le module ou le capuchon.

**10.** Dispositif à semiconducteur selon l'une quelconque des revendications précédentes, dans lequel le coefficient de dilatation thermique de la couche intermédiaire 15, 25, 35, 45, 85) est entre celui du module (11, 21) ou éventuellement du capuchon et celui de la couche adhésive (16, 24, 46, 84).

**11.** Dispositif à semiconducteur selon l'une quelconque des revendications précédentes, dans lequel ledit composant principal de la première couche intermédiaire (15, 35, 45) et du module (11) ou capuchon est un matériau de céramique.

**12.** Dispositif à semiconducteur selon la revendication 11, dans lequel ledit composant principal est de l'alumine, du nitrure d'aluminium ou de la mullite, la couche intermédiaire ou chaque couche intermédiaire (15, 35, 45) comprenant une pâte incluant ce matériau de céramique.

**13.** Dispositif à semiconducteur selon la revendication 11 ou 12, dans lequel la première couche intermédiaire (15, 35) contient du verre.

**14.** Dispositif à semiconducteur selon l'une quelconque des revendications 1 à 10, dans lequel ledit composant principal de la première couche intermédiaire (25, 85) et du module (21) ou capuchon est une résine.

**15.** Dispositif à semiconducteur selon la revendication 14, dans lequel la couche intermédiaire (25, 85) comprend une réserve de soudage à base d'époxy.

**16.** Procédé de fabrication d'un dispositif à semiconducteur incluant un module (11, 21), une puce semiconductrice (12, 22) montée sur le module et un capuchon (13, 23) scellant la puce, le procédé comprenant les étapes de :

formation, au moyen d'un processus d'impression par sérigraphie, d'une pâte sur une zone prédéterminée du module (11, 21), la pâte comportant un composant principal qui est le même que celui du module ;

frittage ou durcissement de la pâte à une température prédéterminée de telle sorte qu'une couche intermédiaire (15, 25, 35) soit formée sur la zone prédéterminée du module ; et

fixation du capuchon (13, 23) à la couche intermédiaire en utilisant un adhésif (16, 24, 84) prévu entre la couche intermédiaire et le capuchon.

**17.** Procédé de fabrication d'un dispositif à semiconducteur, comprenant les étapes de :

formation, au moyen d'un processus d'impression par sérigraphie, d'une pâte sur une zone prédéterminée d'un module (11), la pâte comportant un composant significatif qui est le même que celui du module ;

traitement thermique de la pâte à une température prédéterminée de telle sorte qu'une couche intermédiaire (45) soit formée sur la zone prédéterminée du module (11) ;

fixation d'une puce semiconductrice (12) à la couche intermédiaire (45) en utilisant un adhésif (46) prévu entre la couche intermédiaire (45) et la puce semiconductrice (12) ; et

fixation d'un moyen de scellement (13, 100) au module afin de sceller la puce semiconductrice (12).

**18.** Procédé selon la revendication 16 ou 17, dans lequel le composant principal de la pâte est de l'alumine.

**19.** Procédé selon la revendication 18, dans lequel la pâte inclut du verre en addition à l'alumine.

**20.** Procédé selon la revendication 16 ou 17, dans lequel le module (21) comprend une résine époxy à base de verre.

**21.** Procédé selon la revendication 21, dans lequel la couche intermédiaire (25, 85) est une couche de réserve de soudage à base d'époxy.

**22.** Procédé selon la revendication 21, dans lequel le traitement thermique de la pâte comprend le durcissement de la pâte à une température prédéterminée.

# FIG.1 PRIOR ART

*1*

4    5

2    3

# FIG.2

4    5a    2a

5    2

a

EP 0 434 392 B1

# FIG. 3 <u>10</u>

# FIG.4

# FIG.5

# FIG.6

<u>20</u>

# FIG.7

# FIG.8

# FIG.9

# FIG.10

<u>40</u>

# FIG.11

<u>50</u>

# FIG.12 60

# FIG.13

# FIG.14  70